# EUROPEAN PATENT SPECIFICATION

(11) **EP 3 866 284 B1**
(45) Date of publication and mention of the grant of the patent: **24.06.2026**
(21) Application number: 18936543.0
(22) Date of filing: 09.10.2018
(51) Int. Cl.: H01H 33/56, H01H 33/42, H01H 31/00, H02B 13/035, H02B 1/22

(54) **GAS-INSULATED SWITCHGEAR**
GASISOLIERTES SCHALTGETRIEBE
APPAREILLAGE DE COMMUTATION ISOLÉ AU GAZ

(43) Date of publication of application: 18.08.2021
(73) Proprietor: Mitsubishi Electric Corporation, Tokyo 100-8310 (JP)
(72) Inventor: INOUE, Naoaki, Tokyo 100-8310 (JP); NAKAYAMA, Yuta, Tokyo 100-8310 (JP); TADA, Keisuke, Tokyo 102-0073 (JP)
(74) Representative: Witte, Weller & Partner Patentanwälte mbB
(86) International application number: PCT/JP2018/037522
(87) International publication number: WO 2020/075214

(56) References cited:
- CN-A- 102 044 849
- CN-Y- 201 118 138
- JP-A- 2007 028 776
- JP-A- 2013 192 369
- JP-A- H04 292 824
- JP-A- H1 127 816
- JP-U- H0 636 175
- JP-U- H0 636 175
- JP-U- H02 130 468
- JP-U- S58 152 734
- JP-Y1- S4 520 111
- US-A- 4 161 316
- US-A- 5 175 403

## Description

### Technical Field

The present application relates to the field of a gas insulated switchgear.

### Background Art

A gas insulated switchgear is such that the superior insulation performance of an insulating gas, such as an SF₆ gas, compactifies a main circuit device, such as a circuit breaker, a disconnector, or a grounding switch, thereby contributing to a reduction in the space of an electric chamber. Also, the gas insulated switchgear is such that the main circuit device to be applied with high voltage is housed in a hermetically closed container, and the previously described SF₆ gas superior in insulation performance is sealed in the hermetically closed container, thereby compactifying the main circuit device disposition. Also, in recent years, there is also a case in which in place of the SF₆ gas, an even environmentally superior gas, such as dry air, is sealed as a substitute gas.

In this kind of gas insulated switchgear, the main circuit device, such as a circuit breaker, a disconnector, or a grounding switch, which is disposed in the hermetically closed container is required to be operated by an operating mechanism disposed outside the hermetically closed container. For this reason, a hermetic connecting shaft which, while maintaining the hermeticity of the hermetically closed container, transmits the drive force of the operating mechanism to the main circuit device in the hermetically closed container is used.

Document CN 102044849 A shows a box-sharing gas-insulated metal enclosed switching device. An upper sealed air box and a lower sealed air box are arranged in a cabinet body; a three-position isolating switch, a main bus casing and a main bus are arranged in the upper air box; an output shaft of a three-position spring operating mechanism extends into the upper air box and is connected with the three-position isolating switch through a rotary sealed connector; the three-position isolating switch is connected with a vacuum circuit breaker in the lower air box through a bus connector; the vacuum circuit breaker is connected with a spring mechanism through a metal corrugated pipe sealing mechanism; the vacuum circuit breaker is connected with an inner conical insulator which is sealed and fixed on the wall of the lower air box through a lead; and the inner conical insulator is inserted into a voltage transformer, a cable joint, a zero sequence transformer and a lightning arrester respectively. The switching device has the characteristics of good sealing effect, long service life, small size and wide application range and is safe and reliable.

Document US 5175403 A shows an interrupted electric circuit recloser for reclosing an interrupted high voltage electric circuit system and a solenoid to be utilized for use in a sealed pressurized dielectric gaseous atmosphere. The recloser has a sealed tank and a solenoid therein. The solenoid has a plunger connected through a yoke for returning vacuum contact back to a closed contacting position, a dampener for regulating the opening movement of the plunger, a dielectric gas filling the sealed chamber and permeating the solenoid and acted on by the solenoid plunger. The solenoid also has a central chamber complimentarily accepting the plunger. The central chamber of the solenoid is substantially closed at one end and permits the ingress of the dielectric gas when the plunger is moved in an outward direction within the central chamber away from the closed end and a second dampener controlling the solenoid plunger's movement toward the closed end.

Document US 4161316 A shows a gastight seal arrangement for an actuating rod that passes through a wall of a gas-filled enclosure is described. The actuating rod includes a pair of flanges that are spaced longitudinally of the rod and are positioned on opposite sides of the wall of the enclosure. Impact seals on the interior and exterior of the wall surround the actuating rod and are engaged by the respective flanges corresponding to the position of the rod. Additional seal members are provided in the interior of the wall to prevent leakage along the surface of the actuating rod.

Document JP S4520111 Y1 shows a gastight seal arrangement as well.

Document CN 201118138 Y shows a transmission shaft sealing device that can meet the utilization requirements of air-insulating metal enclosed switchgear; the sealing device has the advantages of simple structure and convenient installation. The device comprises a transmission shaft, a bearing, a shaft sleeve, and a sealing ring that is arranged between the transmission shaft and the shaft sleeve; the shaft sleeve is connected with the switchgear through a flange; the flange blocks the shaft sleeve in the radial direction of the transmission shaft. The sealing device has the characteristics that two groups of bearings are arranged on the transmission shaft; one group of bearings are arranged near one end of the transmission shaft, which extends into the switchgear; the other group of bearings are arranged near the other end of the transmission shaft, which extends out of the switchgear; and the sealing ring is arranged between the two groups of bearings.

Document JP H 1127816 A shows that a junction shaft is fitted, which penetrates a partition plate 4 for partitioning a section between an operation device box and a unit body part and makes linear displacement. An output shaft of an operation device is jointed to one end of the junction shaft through the first displacement transmission mechanism which converts rotational displacement into linear displacement, and the other end of the junction shaft is jointed to the rotation operating shaft of a switch through the second displacement transmission mechanism which converts linear displacement into rotational displacement.

Document JPH0636175U discloses another gas insulated switchgear with a hermetic shaft assembly.

### Summary of Invention

### Technical Problem

As previously described, in the gas insulated switchgear, it is necessary to use the hermetic connecting shaft which, while maintaining the hermeticity of the hermetically closed container, transmits the drive force of the operating mechanism to the main circuit device in the hermetically closed container. Specifically, a structure is such that a hermetic sealing plate is attached around the connecting shaft, and that a hermeticity maintaining member is attached inside the hermetic sealing plate, and thereby it is possible, when the connecting shaft is linearly driven or rotationally driven, to transmit the drive force while maintaining the hermeticity of the hermetically closed container.

However, the hermeticity maintaining member to be attached to a common, hermetically closed lid plate portion is merely attached and hermetically closed when a product is assembled, and on the other hand, in the portion of the hermetic connecting shaft, there occurs, for example, a deterioration of the hermetic connecting shaft caused by a plurality of times of sliding or a deterioration of the hermeticity maintaining member caused by penetration thereinto of dust particles from outside the hermetically closed container when the hermetic connecting shaft operates, so that the portion of the hermetic connecting shaft deteriorates quickly as compared with a hermetic portion, such as a common lid plate. For this reason, there is also a case in which replacement is required at the time of maintenance in several decades' time. On the other hand, according to a gas insulated vacuum circuit breaker disclosed in document WO 2010/134442 A1, the hermetic sealing plate and the hermeticity maintaining member are disposed inside the hermetically closed container, so that it is necessary, in order to carry out the replacement, to carry out replacement work in the state in which the insulating gas in the hermetically closed container is collected and the inside of the hermetically closed container is opened. Consequently, there is a problem in that replacing hours during maintenance are lengthened, overloading the replacement work.

The present application has been made to solve the above problem, and an object of the present application is to provide a gas insulated switchgear which suppresses the elongation of work hours during maintenance by achieving labor savings in the maintenance and, as a result, is improved in maintainability.

### Solution to Problem

A gas insulated switchgear according to the invention is defined in claim 1.

### Advantageous Effects of Invention

According to the gas insulated switchgear disclosed in the present application, it is possible to carry out the work of replacing the hermetic sealing member without collecting the insulating gas inside the hermetically sealed container, so that it is possible to obtain a gas insulated switchgear which can achieve labor savings in maintenance and suppress the elongation of work hours during the maintenance and, as a result, is improved in maintainability.

### Brief Description of Drawings

[Fig. 1] Fig. 1 is a sectional side view showing a gas insulated switchgear according to the first embodiment.
[Fig. 2] Fig. 2 is a sectional view showing a hermetic connecting shaft of a gas insulated switchgear according to a comparison example not falling under the claimed invention.
[Fig. 3] Fig. 3 is a sectional view showing a hermetic connecting shaft of the gas insulated switchgear according to the first embodiment, which falls under the claimed invention.
[Fig. 4] Fig. 4 is a sectional view showing the structure of a connecting portion of the hermetic connecting shaft shown in Fig. 3.
[Fig. 5] Fig. 5 is a sectional view showing a hermetic connecting shaft of a gas insulated switchgear according to the second embodiment not falling under claimed invention. Description of Embodiments

Hereinafter, a description will be given, based on the drawings, of a gas insulated switchgear according to the first embodiment.

In the individual drawings, identical signs show identical or equivalent portions.

### First Embodiment

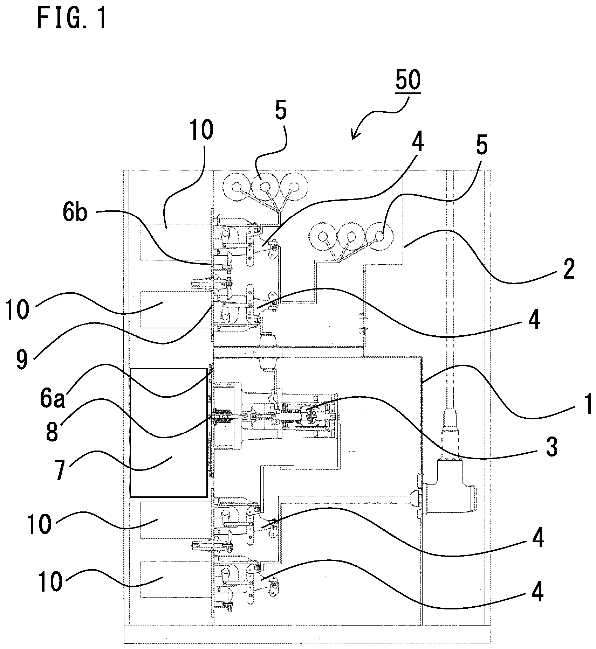

Fig. 1 is a sectional side view of the gas insulated switchgear shown in the first embodiment. As shown in Fig. 1, a circuit breaker tank 1 and a bus bar tank 2, which are hermetically closed containers, are included inside a gas insulated switchgear 50, and the bus bar tank 2 is disposed on the top of the circuit breaker tank 1. Bus bars 5 and main circuit devices, such as disconnectors or grounding switches 4, are housed in the bus bar tank 2. Also, a plurality of main circuit devices including a circuit breaker 3 are housed in the circuit breaker tank 1. Also, disconnectors or grounding switches 4 are also disposed in the circuit breaker tank 1.

The circuit breaker 3 is hermetically closed (sealed) while being inserted in the circuit breaker tank 1 in the state of being attached to a circuit breaker flange 6a which separates the inside from the outside of the circuit breaker tank 1. Also, a circuit breaker operating mechanism 7 is attached to a side of the circuit breaker flange 6a outside the circuit breaker tank 1. That is, the backside of the gas insulated switchgear 50, which is the sheet's right side of the circuit breaker flange 6a, is in the circuit breaker tank 1 and is in the state in which an insulating gas, such as SF₆ or dry air, is sealed therein. Also, the foreside of the gas insulated switchgear 50, which is the sheet's left side of the circuit breaker flange 6a, is outside the circuit breaker tank 1 and so is in the atmosphere. The gas insulated switchgear 50 in the first embodiment includes a hermetic connecting portion 8 of a circuit breaker section in order to transmit the drive force of the circuit breaker operating mechanism 7 in the atmosphere to the circuit breaker 3 in the circuit breaker tank 1.

Also, the disconnectors or grounding switches 4 are hermetically closed (sealed) while being inserted in the bus bar tank 2 in the state of being attached to a disconnector or grounding-switch flange 6b which separates the inside from the outside of the bus bar tank 2. Also, disconnector or grounding-switch operating mechanisms 10 are attached to a side of the disconnector or grounding-switch flange 6b outside the bus bar tank 2. That is, the backside of the gas insulated switchgear 50, which is the sheet's right side of the disconnector or grounding-switch flange 6b, is in the bus bar tank 2 and is in the state in which an insulating gas, such as SF₆ or dry air, is sealed therein. Also, the foreside of the gas insulated switchgear 50, which is the sheet's left side of the disconnector or grounding-switch flange 6b, is outside the bus bar tank 2 and so is in the atmosphere. The gas insulated switchgear 50 in the first embodiment includes a hermetic connecting portion 9 of a disconnector or grounding-switch section in order to transmit the drive force of the disconnector or grounding-switch operating mechanisms 10 in the atmosphere to the disconnectors or grounding switches 4 in the bus bar tank 2.

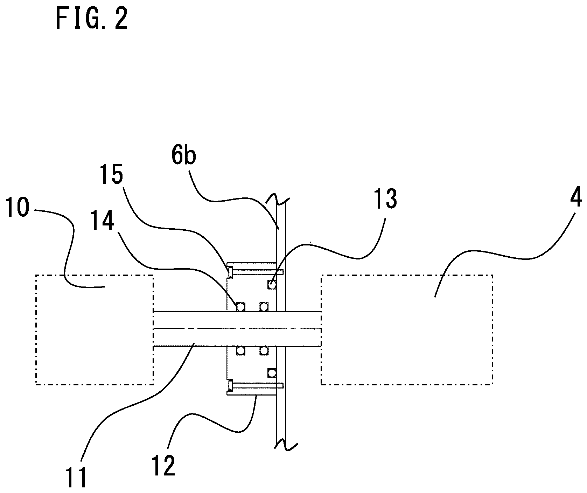

Fig. 2 is a sectional view showing a hermetic connecting shaft of a gas insulated switchgear not according to the claimed invention. A description will be given of a hermetic connecting shaft 11 with the disconnector or grounding-switch section exemplified herein, but the same applies to the circuit breaker section. In the gas insulated switchgear 50, the disconnector or grounding switch 4 is disposed in the interior of the bus bar tank 2 shown on the sheet's right side across the disconnector or grounding-switch flange 6b. Also, in the gas insulated switchgear 50, the disconnector or grounding-switch operating mechanism 10 is disposed in the atmosphere on the outside of the bus bar tank 2 shown on the sheet's left side of the disconnector or grounding-switch flange 6b. Also, the disconnector or grounding-switch operating mechanism 10 and the disconnector or grounding switch 4 are connected together by the hermetic connecting shaft 11 in order to transmit the drive force of the disconnector or grounding-switch operating mechanism 10 to the disconnector or grounding switch 4 in the bus bar tank 2. Also, the hermetic connecting shaft 11 penetrates a hermetic sealing component 12 in order to hermetically close (seal) the periphery of the hermetic connecting shaft 11.

A groove is formed in a surface of the hermetic sealing component 12 in contact with the disconnector or grounding-switch flange 6b, and a hermetic sealing member 13 for hermetic sealing component fixing portion use is attached in the groove. The hermetic sealing member 13 is of a seal material, for example, in the form of a rubber O-ring or T-ring.

Also, a hole portion through which to insert the hermetic connecting shaft 11 is provided in the center of the hermetic sealing component 12. Also, grooves are also provided around the hole portion which is in the center of the hermetic sealing component 12 and in which the hermetic connecting shaft 11 is inserted, and hermetic sealing members 14 for hermetic connecting shaft sliding use are disposed in the respective grooves.

Fig. 2 shows a case in which two hermetic sealing members 14 for hermetic connecting shaft sliding use are disposed inside the hermetic sealing component 12 for the purpose of an improvement in the hermetic sealability against sliding of the hermetic connecting shaft 11, but even when one hermetic sealing member 14 for hermetic connecting shaft sliding use is disposed, it remains the same in function.

Owing to this structure, the portions on the hermetic connecting shaft 11 and hermetic sealing component 12 are hermetically closed (sealed) by the hermetic sealing member 13 for hermetic sealing component fixing portion use and by the hermetic sealing members 14 for hermetic connecting shaft sliding use, so that it is possible, by sliding of the hermetic connecting shaft 11 while maintaining the hermeticity in the bus bar tank 2, to transmit the drive force of the disconnector or grounding-switch operating mechanism 10 to the disconnector or the grounding switch 4 in the bus bar tank 2.

The hermetic sealing component 12 itself is fastened to the disconnector or grounding-switch flange 6b by hermetic sealing component fixing bolts 15.

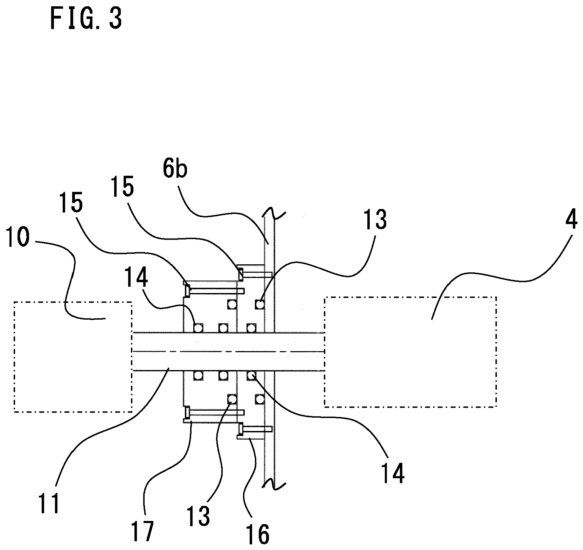

Fig. 3 is a sectional view of a hermetic connecting shaft of the gas insulated switchgear shown in the first embodiment.

As shown in Fig. 3, in the gas insulated switchgear 50, the disconnector or grounding switch 4 is disposed in the interior of the bus bar tank 2 shown on the sheet's right side across the disconnector or grounding-switch flange 6b. Also, in the gas insulated switchgear 50, the disconnector or grounding-switch operating mechanism 10 is disposed in the atmosphere on the outside of the bus bar tank 2 shown on the sheet's left side of the disconnector or grounding-switch flange 6b. Also, the disconnector or grounding-switch operating mechanism 10 and the disconnector or grounding switch 4 are connected together by the hermetic connecting shaft 11 in order to transmit the drive force of the disconnector or grounding-switch operating mechanism 10 to the disconnector or grounding switch 4 in the bus bar tank **2.** In order to hermetically close (seal) the periphery of the hermetic connecting shaft 11, the hermetic connecting shaft 11 penetrates a first hermetic sealing portion 16 which is a first hermetic sealing portion and a second hermetic sealing portion 17 which is a second hermetic sealing portion.

The first hermetic sealing portion 16 is formed from, for example, a metal, and a groove is formed in a surface of the first hermetic sealing portion 16 in contact with the disconnector or grounding-switch flange 6b, and a hermetic sealing member 13 for hermetic sealing component fixing portion use is attached in the groove. The hermetic sealing member 13 is of a seal material, for example, in the form of a rubber O-ring or T-ring.

Also, a hole portion through which to insert the hermetic connecting shaft 11 is provided in the center of the first hermetic sealing portion 16. Also, a groove is also provided around the hole portion which is in the center of the first hermetic sealing portion 16 and in which the hermetic connecting shaft 11 is inserted, and a hermetic sealing member 14 for hermetic connecting shaft sliding use is disposed in the groove. The difference from the comparison example shown in Fig. 2 is that in the first embodiment, only one hermetic sealing member 14 for hermetic connecting shaft sliding use is disposed inside the first hermetic sealing portion 16 for the purpose of an improvement in the hermetic sealability against sliding of the hermetic connecting shaft 11. The first hermetic sealing portion 16 itself is attached to the disconnector or grounding-switch flange 6b and is fastened thereto by hermetic sealing component fixing bolts 15.

Also, the second hermetic sealing portion 17, being formed from, for example, a metal, is disposed around the hermetic connecting shaft 11 so as to be superimposed on the first hermetic sealing portion 16, and is attached to the first hermetic sealing portion 16. A groove is formed in a surface of the second hermetic sealing portion 17 in contact with the surface of the first hermetic sealing portion 16, and a hermetic sealing member 13 for hermetic sealing component fixing portion use is attached in the groove. The hermetic sealing member 13 is of a seal material, for example, in the form of a rubber O-ring or T-ring. Also, a hole portion through which to insert the hermetic connecting shaft 11 is provided in the center of the second hermetic sealing portion 17. Also, grooves are also provided around the hole portion which is in the center of the second hermetic sealing portion 17 and in which the hermetic connecting shaft 11 is inserted, and hermetic sealing members 14 for hermetic connecting shaft sliding use are disposed in the respective grooves. The second sealing component 17 itself is fastened to the first hermetic sealing portion 16 by hermetic sealing component fixing bolts 15.

The first hermetic sealing portion 16 and the second hermetic sealing portion 17 are provided in the atmosphere outside the bus bar tank 2 which is a hermetically closed container, and the second hermetic sealing portion 17, in the same way as the first hermetic sealing portion 16, includes the hermetic sealing member 13 for hermetic sealing component fixing portion use and the hermetic sealing members 14 for hermetic connecting shaft sliding use. According to the gas insulated switchgear 50 according to the first embodiment, the portions on the hermetic connecting shaft 11, first hermetic sealing portion 16, and second hermetic sealing portion 17 are hermetically closed (sealed) by the hermetic sealing members 13 for hermetic sealing component fixing portion use and the hermetic sealing members 14 for hermetic connecting shaft sliding use, so that it is possible, by sliding of the hermetic connecting shaft 11 while maintaining the hermeticity in the bus bar tank 2, to transmit the drive force of the disconnector or grounding-switch operating mechanism 10 to the disconnector or grounding switch 4 in the bus bar tank 2.

Also, as shown in Fig. 3, in the first embodiment, a case is shown in which the plurality of hermetic sealing members 14 for hermetic connecting shaft sliding use are disposed inside the second hermetic sealing portion 17 for the purpose of an improvement in the hermetic sealability against sliding of the hermetic connecting shaft 11, but even when one hermetic sealing member 14 for hermetic connecting shaft sliding use is inside the second hermetic sealing portion 17, it remains the same in function.

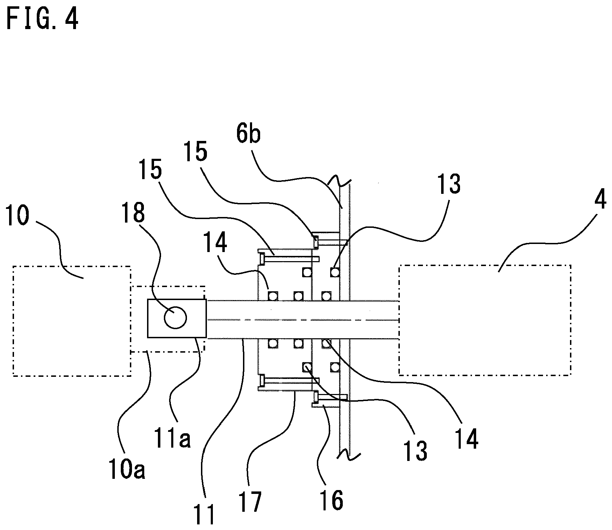

Fig. 4 is a sectional view showing a connecting portion structure of the hermetic connecting shaft of the gas insulated switchgear shown in the first embodiment. The hermetic connecting shaft 11 has at its in-atmosphere side leading end a hermetic connecting shaft connecting portion 11a, and the disconnector or grounding-switch operating mechanism 10 has a disconnector or grounding-switch operating mechanism connecting portion 10a, adopting a structure in which the two connecting portions are connected to each other by a connecting component 18. The connecting component 18 is a pin or a bolt, and the disconnector or grounding-switch operating mechanism connecting portion 10a and the hermetic connecting shaft connecting portion 11a are pin fastened or bolt fastened to each other.

The hermetic connecting shaft of the gas insulated switchgear according to the non-claimed example of Fig. 2 is of a structure such that one hermetic sealing component 12 is attached around the hermetic connecting shaft 11, so that when the hermetic sealing members 14 in the hermetic sealing component 12 deteriorate and need to be replaced, it has been required, in order to replace the hermetic sealing members 14, that after the insulating gas in the bus bar tank 2 is collected, putting the inside of the bus bar tank 2 into the state of the atmosphere, the hermetic sealing component 12 is removed, and then the hermetic sealing members 14 are replaced. The reason for this is that gas leakage may occur when the hermetic sealing component 12 is removed.

On the other hand, the hermetic connecting shaft of the gas insulated switchgear according to the first embodiment shown in Fig. 3 is such that the first hermetic sealing portion 16 and the second hermetic sealing portion 17 are disposed around the hermetic connecting shaft 11, and the first hermetic sealing portion 16 is attached and fixed to the disconnector or grounding-switch flange 6b by the hermetic sealing component fixing bolts 15. The second hermetic sealing portion 17, being disposed around the hermetic connecting shaft 11 so as to be superimposed on the first hermetic sealing portion 16, is attached to the first hermetic sealing portion 16 and is fastened to the first hermetic sealing portion 16 by the hermetic sealing component fixing bolts 15. The second hermetic sealing portion 17, in the same way as the first hermetic sealing portion 16, has the hermetic sealing member 13 for hermetic sealing component fixing portion use and the hermetic sealing members 14 for hermetic connecting shaft sliding use.

As for the hermetic connecting shaft 11 of the gas insulated switchgear according to the first embodiment, when replacing the hermetic sealing members 14 for hermetic connecting shaft sliding use, the connecting component 18 which connects the disconnector or grounding-switch operating mechanism 10 and the hermetic connecting shaft 11 is removed, the disconnector or grounding-switch operating mechanism 10 is removed, the hermetic sealing component fixing bolts 15 which fix the second hermetic sealing portion 17 are removed, and the second hermetic sealing portion 17 is removed. Even after the second hermetic sealing portion 17 is removed, the first hermetic sealing portion 16 is still left behind, so that it is possible to prevent a leakage of the insulating gas. For this reason, it is possible, without collecting the insulating gas in the bus bar tank 2 which is a hermetically closed container, to remove the second hermetic sealing portion 17 and replace the hermetic sealing members 14 for hermetic connecting shaft sliding use. Also, it is also possible to replace the hermetic sealing member 13 for hermetic sealing component fixing portion use.

According to the first embodiment, the hermetic sealing members 14 of the second hermetic sealing portion 17 deteriorate quickly due to air or dust in the atmosphere, but the hermetic sealing member 14 of the first hermetic sealing portion 16 does not expose to air or dust in the atmosphere and so can be restrained from deterioration. For this reason, the object of providing the gas insulated switchgear 50 improved in maintainability can be achieved as long as the second hermetic sealing portion 17 is made ready to be easily replaced.

### Second Embodiment - not falling under the claimed invention

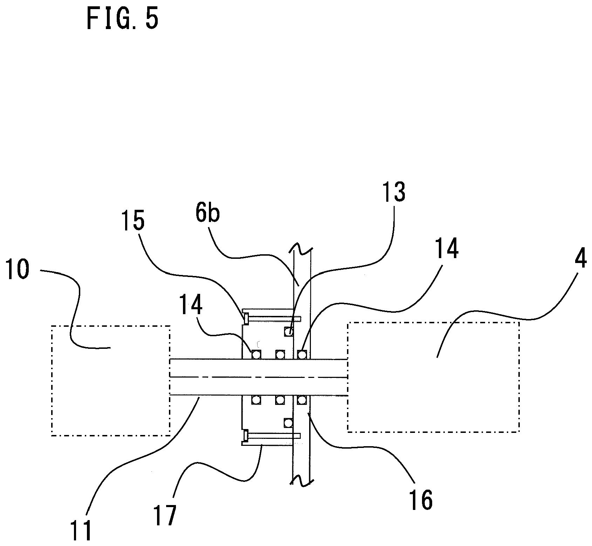

Fig. 5 is a sectional view showing a hermetic connecting shaft of a gas insulated switchgear according to the second embodiment. In the first embodiment, a structure is shown in which the first hermetic sealing portion 16 and the second hermetic sealing portion 17 are disposed, superimposed one on the other, on the disconnector or grounding-switch flange 6b, but in the second embodiment, the inside of the disconnector or grounding-switch flange 6b of the bus bar tank 2 which is a hermetically closed container functions as the first hermetic sealing portion 16 of the first embodiment. Specifically, a groove is formed inside the disconnector or grounding-switch flange 6b formed from a metal, and a hermetic sealing member 14 for hermetic connecting shaft sliding use is disposed in the groove. The first hermetic sealing portion 16 having the hermetic sealing member 14 is disposed around the hermetic connecting shaft 11. Then, the second hermetic sealing portion 17, having thereinside the hermetic sealing members 14, is disposed around the hermetic connecting shaft 11 so as to be superimposed on the first hermetic sealing portion 16, and also is provided in the atmosphere outside the bus bar tank 2 which is a hermetically closed container. The hermetic sealing member 14 of the first hermetic sealing portion 16 and the hermetic sealing members 14 of the second sealing component 17 are disposed around the identical hermetic connecting shaft 11.

In the structure of the first embodiment, a structure to doubly superimpose the first hermetic sealing portion 16 and the second hermetic sealing portion 17 is adopted, thereby increasing the dimension in depth of a product, but in the second embodiment, the disconnector or grounding-switch flange 6b, as it has the function of the first hermetic sealing portion 16 of the first embodiment, is the same in function as in the first embodiment, and there is an advantageous effect in that it is possible to reduce the dimension in depth of the product.

Although the present application is described above in terms of various exemplary embodiments and implementations, it should be understood that the various features, aspects, and functionality described in one or more of the individual embodiments are not limited in their applicability to the particular embodiment with which they are described, but instead can be applied, alone or in various combinations, to one or more of the embodiments.

It is therefore understood that numerous modifications which have not been exemplified can be devised without departing from the scope of the present invention, which is defined in the appended claims.

### Reference Signs List

1 circuit breaker tank, 2 bus bar tank, 3 circuit breaker, 4 disconnector or grounding switch, 5 bus bar, 6a circuit breaker flange, 6b disconnector or grounding-switch flange, 7 circuit breaker operating mechanism, 8 hermetic connecting portion of circuit breaker section, 9 hermetic connecting portion of disconnector or grounding-switch section, 10 disconnector or grounding-switch operating mechanism, 10a disconnector or grounding-switch operating mechanism connecting portion, 11 hermetic connecting shaft, 11a hermetic connecting shaft connecting portion, 12 hermetic sealing component, 13 hermetic sealing member (for hermetic sealing component fixing portion use), 14 hermetic sealing member (for hermetic connecting shaft sliding use), 15 hermetic sealing component fixing bolt, 16 first hermetic sealing portion, 17 second hermetic sealing portion, 18 connecting component, 50 gas insulated switchgear

## Claims

1. A gas insulated switchgear (50), comprising:
a main circuit device (3, 4) disposed inside a container (1,2) in which an insulating gas is hermetically sealed;
an operating mechanism (7,10) disposed outside the container (1,2);
a hermetic connecting shaft (11) which transmits the drive force of the operating mechanism (7,10) to the main circuit device (3,4);
a first hermetic sealing portion (16) which, having thereinside a hermetic sealing member (14), is disposed around the hermetic connecting shaft (11); and
a second hermetic sealing portion (17) which, having thereinside a hermetic sealing member (14), is disposed around the hermetic connecting shaft (11) so as to be superimposed on the first hermetic sealing portion (16) and also is provided in the atmosphere outside the container (1,2),
wherein the second hermetic sealing portion (17) is disposed superimposed so as to have contact with a surface of the first hermetic sealing portion (16), and
the main circuit device (3,4) is attached to a flange (6b) of the container (1,2),
wherein the first hermetic sealing portion (16), being provided in the atmosphere outside the container (1,2), is attached to the flange (6a, 6b) of the container (1,2) by first hermetic sealing component fixing bolts (15),
wherein the second hermetic sealing portion (17) is attached to the first hermetic sealing portion (16) by second hermetic sealing component fixing bolts (15),
wherein the first hermetic sealing portion (16) comprises a groove in a surface in contact with the flange (6b) and a sealing member (13) attached in the groove,
wherein the second hermetic sealing portion (17) comprises a groove in a surface in contact with the first hermetic sealing portion (16) and a sealing member (13) attached in the groove.

2. The gas insulated switchgear (50) according to claim 1,
wherein the sealing members (13) of the first hermetic sealing portion (16) and the second hermetic sealing portion (17) are an O-ring or a T-ring.

3. The gas insulated switchgear (50) according to claim 1 or 2,
wherein a plurality of the hermetic sealing members (14) are disposed inside the second hermetic sealing portion (17) .

4. The gas insulated switchgear (50) according to any one of claims 1 to 3,
wherein the main circuit device (3, 4) either is a circuit breaker (3) or is a disconnector or a grounding switch (4).

## Patentansprüche

1. Gasisolierte Schaltanlage (50), die aufweist:
eine Hauptschaltungsvorrichtung (3,4), die in einem Behälter (1,2) angeordnet ist, in dem ein Isoliergas hermetisch verschlossen ist;
einen Betriebsmechanismus (7,10), der außerhalb des Behälters (1,2) angeordnet ist;
eine hermetische Verbindungswelle (11), die die Antriebskraft des Betriebsmechanismus (7,10) auf die Hauptschaltungsvorrichtung (3,4) überträgt;
einen ersten hermetischen Dichtabschnitt (16), der ein hermetisches Dichtelement (14) im Inneren aufweist und um die hermetische Verbindungswelle (11) angeordnet ist; und
einen zweiten hermetischen Dichtabschnitt (17), der ein hermetisches Dichtelement (14) im Inneren aufweist und um die hermetische Verbindungswelle (11) angeordnet ist, so dass dieser den ersten hermetischen Dichtabschnitt (16) überlagert und außerdem in der Atmosphäre außerhalb des Behälters (1,2) vorgesehen ist,
wobei der zweite hermetische Dichtabschnitt (17) so überlagernd angeordnet ist, dass dieser mit einer Oberfläche des ersten hermetischen Dichtabschnitts (16) in Kontakt steht, und
die Hauptschaltungsvorrichtung (3,4) an einem Flansch (6b) des Behälters (1,2) befestigt ist,
wobei der erste hermetische Dichtabschnitt (16), der in der Atmosphäre außerhalb des Behälters (1,2) vorgesehen ist, am Flansch (6a, 6b) des Behälters (1,2) durch erste Hermetische-Dichtungskomponente-Fixierungsbolzen (15) befestigt ist,
wobei der zweite hermetische Dichtabschnitt (17) an dem ersten hermetischen Dichtabschnitt (16) durch zweite Hermetische-Dichtungskomponente-Fixierungsbolzen (15) befestigt ist,
wobei der erste hermetische Dichtabschnitt (16) eine Nut in einer Oberfläche aufweist, die mit dem Flansch (6b) in Kontakt steht, und ein in der Nut befestigtes Dichtelement (13),
wobei der zweite hermetische Dichtabschnitt (17) eine Nut in einer Oberfläche aufweist, die mit dem ersten hermetischen Dichtabschnitt (16) in Kontakt steht, und ein in der Nut befestigtes Dichtelement (13).

2. Gasisolierte Schaltanlage (50) nach Anspruch 1,
wobei die Dichtelemente (13) des ersten hermetischen Dichtabschnitts (16) und des zweiten hermetischen Dichtabschnitts (17) ein O-Ring oder T-Ring sind.

3. Gasisolierte Schaltanlage (50) nach Anspruch 1 oder 2,
wobei eine Vielzahl der hermetischen Dichtelemente (14) im Inneren des zweiten hermetischen Dichtabschnitts (17) angeordnet sind.

4. Gasisolierte Schaltanlage (50) nach einem der Ansprüche 1 bis 3,
wobei die Hauptschaltungsvorrichtung (3,4) entweder ein Schaltungsunterbrecher (3) oder ein Trennschalter oder ein Erdungsschalter (4) ist.

## Revendications

1. Appareillage de commutation isolé par gaz (50), comprenant :
un dispositif de circuit principal (3, 4) disposé à l'intérieur d'un contenant (1, 2) dans lequel un gaz isolant est hermétiquement scellé ;
un mécanisme d'actionnement (7, 10) disposé à l'extérieur du contenant (1, 2) ;
un arbre de liaison hermétique (11) qui transmet la force d'entraînement du mécanisme d'actionnement (7, 10) au dispositif de circuit principal (3, 4) ;
une première partie d'étanchéité hermétique (16) qui, ayant à l'intérieur de celle-ci un élément d'étanchéité hermétique (14), est disposée autour de l'arbre de liaison hermétique (11) ; et
une seconde partie d'étanchéité hermétique (17) qui, ayant à l'intérieur de celle-ci un élément d'étanchéité hermétique (14), est disposée autour de l'arbre de liaison hermétique (11) de manière à être superposée à la première partie d'étanchéité hermétique (16) et est également placée dans l'atmosphère à l'extérieur du contenant (1, 2),
dans lequel la seconde partie d'étanchéité hermétique (17) est disposée superposée de manière à avoir un contact avec une surface de la première partie d'étanchéité hermétique (16), et
le dispositif de circuit principal (3, 4) est fixé à une bride (6b) du contenant (1, 2),
dans lequel la première partie d'étanchéité hermétique (16), étant placée dans l'atmosphère à l'extérieur du contenant (1, 2), est fixée à la bride (6a, 6b) du contenant (1, 2) par des premiers boulons de fixation (15) de composant d'étanchéité hermétique,
dans lequel la seconde partie d'étanchéité hermétique (17) est fixée à la première partie d'étanchéité hermétique (16) par des seconds boulons de fixation (15) de composant d'étanchéité hermétique,
dans lequel la première partie d'étanchéité hermétique (16) comprend une rainure dans une surface en contact avec la bride (6b) et un élément d'étanchéité (13) fixé dans la rainure,
dans lequel la seconde partie d'étanchéité hermétique (17) comprend une rainure dans une surface en contact avec la première partie d'étanchéité hermétique (16) et un élément d'étanchéité (13) fixé dans la rainure.

2. Appareillage de commutation isolé par gaz (50) selon la revendication 1,
dans lequel les éléments d'étanchéité (13) de la première partie d'étanchéité hermétique (16) et de la seconde partie d'étanchéité hermétique (17) sont un joint torique ou un joint en T.

3. Appareillage de commutation isolé par gaz (50) selon la revendication 1 ou 2,
dans lequel une pluralité des éléments d'étanchéité hermétique (14) sont disposés à l'intérieur de la seconde partie d'étanchéité hermétique (17).

4. Appareillage de commutation isolé par gaz (50) selon l'une quelconque des revendications 1 à 3,
dans lequel le dispositif de circuit principal (3, 4) soit est un disjoncteur (3), soit est un sectionneur, soit est un commutateur de mise à la terre (4).
